# EUROPÄISCHE PATENTANMELDUNG

(11) **EP 3 933 913 A1**
(43) Veröffentlichungstag der Anmeldung: **05.01.2022**
(21) Anmeldenummer: 20183215.1
(22) Anmeldetag: 30.06.2020
(51) Int. Cl.: H01L 23/373, H01L 23/467, H01L 25/07, H01L 21/48, H01L 23/498, H01L 23/538

(54) **LEISTUNGSMODUL MIT MINDESTENS ZWEI LEISTUNGSEINHEITEN**

(71) Anmelder: Siemens Aktiengesellschaft, 80333 München (DE)
(72) Erfinder: Schmenger, Jens, 91301 Forchheim (DE); Koegler, Roman, 90403 Nürnberg (DE); Luft, Alexander, 90766 Fürth (DE); Namyslo, Lutz, 91353 Hausen (DE); Roppelt, Bernd, 96191 Viereth-Trunstadt (DE); Schwinn, Thomas, 91074 Herzogenaurach (DE)

(57) **Zusammenfassung**

Die Erfindung betrifft ein Leistungsmodul (2) mit mindestens zwei Leistungseinheiten (4), welche jeweils mindestens einen Leistungshalbleiter (6) und ein Substrat (8) umfassen. Um den erforderlichen Bauraum des Leistungsmoduls zu verringern und eine Entwärmung zu verbessern, wird vorgeschlagen, dass der jeweils mindestens eine Leistungshalbleiter (6), insbesondere stoffschlüssig, mit dem jeweiligen Substrat (8) verbunden ist, wobei die Substrate (8) der mindestens zwei Leistungseinheiten (4) jeweils unmittelbar stoffschlüssig mit einer Oberfläche (24) eines gemeinsamen Kühlkörpers (26) verbunden sind.

## Beschreibung

Die Erfindung betrifft ein Leistungsmodul mit mindestens zwei Leistungseinheiten.

Darüber hinaus betrifft die Erfindung einen Stromrichter mit mindestens einem derartigen Leistungshalbleitermodul.

In derartigen Stromrichtern werden in der Regel, insbesondere durch ein Gehäuse, abgeschlossene Schalter-Module, die derzeit in diskreten Bauformen gefertigt werden, beispielweise über eine massive metallische Bodenplatte, auf einen Kühlkörper aufgeschraubt. Unter einem Stromrichter ist beispielsweise ein Gleichrichter, ein Wechselrichter, ein Umrichter oder ein Gleichspannungswandler zu verstehen.

Die Offenlegungsschrift DE 10 2009 001 722 A1 beschreibt ein Leistungshalbleitermodul, dessen Bodenplatte als Mehrschichtsubstrat ausgebildet und mit einer ausgehärteten Wärmeleitpaste versehen ist, und das mit einem Kühlkörper in thermischen Kontakt gebracht wird.

Die Offenlegungsschrift DE 10 2010 022 562 A1 beschreibt ein elektrisches Leistungsmodul zur Montage auf einer Leiterplatte, umfassend eine erste Seite zur Montage auf einer Oberfläche einer Wärmesenke, wobei die erste Seite in einer montierten Position des elektrischen Leistungsmoduls auf der Wärmesenke im Wesentlichen parallel zur Wärmesenke angeordnet ist, und eine mit elektrischen Verbindungselementen versehene zweite Seite, wobei die elektrischen Verbindungselemente angepasst sind, das elektrische Leistungsmodul mit der Leiterplatte elektrisch zu verbinden. Das elektrische Leistungsmodul kann auf einfachere Weise mit der Leiterplatte und der Wärmesenke verbunden werden, wenn das elektrische Leistungsmodul mindestens ein dübelartiges Befestigungselement umfasst oder angepasst ist, mindestens ein dübelartiges Befestigungselement aufzunehmen, das in mindestens eine Bohrung der Wärmesenke einführbar ist und angepasst ist, ein Festklemmelement so aufzunehmen, dass das Festklemmelement durch seine Einführung in das mindestens eine dübelartige Befestigungselement in der mindestens einen Bohrung der Wärmesenke festklemmt.

Die Offenlegungsschrift EP 3 624 184 A1 beschreibt ein Verfahren zur Herstellung einer Leistungsmoduleinheit, wobei eine Grundplatte mit Aussparungen versehen wird. Die Grundplatte wird mit einem Substrat, welches den Leistungshalbleiter trägt, verbunden. Nach der Befestigung des Substrates auf der Grundplatte werden die Kühlrippen in die Aussparungen der Grundplatte geführt und formschlüssig und/oder kraftschlüssig befestigt.

Die Patentschrift DE 10 2008 007 310 B4 beschreibt einen elektrischen Einpresskontakt, insbesondere Einpressstiftkontakt, zur Übertragung von elektrischem Strom und/oder elektrischen Signalen, mit einem Einpressabschnitt und einem Montageabschnitt, die über einen Entlastungsabschnitt miteinander mechanisch gekoppelt sind, und der Entlastungsabschnitt einen Ausgleichsbereich und einen Anschlagbereich aufweist, wobei der Ausgleichsbereich eine gekoppelte Relativbewegung des Einpressabschnitts und des Montageabschnitts zulässt, und der Anschlagbereich eine Aufeinanderzubewegung von Einpressabschnitt und Montageabschnitt blockiert, und wobei der Anschlagbereich des Entlastungsabschnitts symmetrisch bezüglich einer Kraftmittellinie des elektrischen Einpresskontakts angeordnet ist, entlang welcher eine Einpresskraft in den elektrischen Einpresskontakt einleitbar ist, die aus einem Einpressen des elektrischen Einpresskontakts in einen Träger resultiert.

Vor diesem Hintergrund ist es eine Aufgabe der vorliegenden Erfindung, den erforderlichen Bauraum von Leistungsmodulen zu verringern und eine Entwärmung zu verbessern.

Die Aufgabe wird erfindungsgemäß gelöst durch ein Leistungsmodul mit mindestens zwei Leistungseinheiten, welche jeweils mindestens einen Leistungshalbleiter und ein Substrat umfassen, wobei der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Darüber hinaus wird die Aufgabe erfindungsgemäß durch einen Stromrichter mit zumindest einem derartigen Leistungsmodul gelöst.

Die in Bezug auf das Leistungsmodul nachstehend angeführten Vorteile und bevorzugten Ausgestaltungen lassen sich sinngemäß auf den Stromrichter übertragen.

Der Erfindung liegt die Überlegung zugrunde, den Platzbedarf eines Leistungsmoduls durch Reduzierung der Anzahl thermischer Schnittstellen zu verringern und dabei eine verbesserte Entwärmung zu erreichen. Ein derartiges Leistungsmodul weist mindestens zwei Leistungseinheiten auf, wobei die Leistungseinheiten jeweils mindestens einen Leistungshalbleiter und ein Substrat umfassen. Ein Substrat ist eine beidseitig metallisierte dielektrische Materiallage, wobei die dielektrische Materiallage beispielsweise eine Dicke d von 25 µm bis 400 µm, insbesondere 50 µm bis 250 µm, aufweist. Ferner enthält die dielektrische Materiallage einen keramischen Werkstoff, beispielsweise Aluminiumnitrid oder Aluminiumoxid, oder einen organischen Werkstoff, beispielsweise einem Polyamid. Insbesondere enthält die Metallisierung Kupfer, Molybdän, Gold und/oder Silber. Ferner kann zumindest eine Seite der Metallisierung des Substrats strukturiert ausgebildet sein. Der Leistungshalbleiter ist insbesondere als ein Transistor und/oder eine Diode, ausgeführt, wobei der Transistor beispielsweise als Insulated-Gate-Bipolar-Transistor (IGBT), als Metalloxide-Semiconductor-Field-Effect-Transistor (MOSFET) oder als ein Feldeffekttransistor ausgeführt ist.

Der jeweils mindestens eine Leistungshalbleiter ist, insbesondere stoffschlüssig, z.B. über eine Sinterverbindung oder Lötverbindung, mit dem jeweiligen Substrat verbunden.

Die Substrate der Leistungseinheiten sind jeweils, insbesondere mit einer dem mindestens einen Leistungshalbleiter abgewandten Seite, unmittelbar stoffschlüssig mit einer Oberfläche eines gemeinsamen Kühlkörpers verbunden. Unter einer unmittelbar stoffschlüssigen Kontaktierung ist eine direkte Kontaktierung zu verstehen, die Verbindungsmittel zur Herstellung der stoffschlüssigen Verbindung wie Kleber, Lötzinn, Sinterpaste, ... einschließt, ein zusätzliches Verbindungselement wie einen zusätzlichen Leiter, einen Bonddraht, einen Abstandshalter, eine Bodenplatte, Wärmeleitpaste, ... jedoch ausschließt. Durch den Wegfall eines derartigen zusätzlichen Verbindungselements wird eine verbesserte thermische Anbindung der Leistungshalbleiter erreicht, sodass eine verbesserte Entwärmung stattfindet. Darüber hinaus wird durch die unmittelbar stoffschlüssige Verbindung Bauraum eingespart. Durch eine stoffschlüssige Verbindung von mindestens zwei Leistungseinheiten auf einem gemeinsamen Kühlkörper ergibt sich eine hohe Flexibilität hinsichtlich der Positionierung der Leistungseinheiten auf der Oberfläche des Kühlkörpers, um durch Wärmespreizung eine optimierte Entwärmung zu erzielen und die Oberfläche des Kühlkörpers maximal auszunutzen.

Eine weitere Ausführungsform sieht vor, dass die Substrate der Leistungseinheiten jeweils eine dielektrische Materiallage mit einer Wärmeleitfähigkeit von mindestens 25 W·m-1·K-1, insbesondere mindestens 100 W·m-1·K-1, und einer Dicke von 25 µm bis 400 µm, insbesondere 50 µm bis 250 µm, aufweisen. Beispielsweise ist die dielektrische Materiallage aus Aluminiumnitrid oder Aluminiumoxid hergestellt. Insbesondere durch die mehreren stoffschlüssig auf der Kühlkörperoberfläche verbundener Substrate wird eine Verwendung von derartig dünnen keramischen Schichten ermöglicht, was zu einer Verbesserung der thermischen Anbindung der Leistungshalbleiter führt.

Eine weitere Ausführungsform sieht vor, dass die mindestens zwei Leistungseinheiten ein gemeinsames Gehäuse aufweisen. Ein derartiges gemeinsames Gehäuse ist beispielsweise aus einem Kunststoff hergestellt. Durch das gemeinsame Gehäuse wird Bauraum eingespart.

Eine weitere Ausführungsform sieht vor, dass die mindestens zwei Leistungseinheiten, insbesondere über eine Bondverbindung, elektrisch leitend miteinander verbunden sind. Eine derartige Bondverbindung wird beispielsweise über Bonddrähte oder Ribbon-Bonds hergestellt. Beispielsweise sind identische Leistungseinheiten über die Bondverbindung parallel zusammenschaltbar, um einen höheren Laststrom zu treiben. Durch einen derartigen modularen Aufbau können Leistungsmodule kostengünstig skalierbar hergestellt werden.

Eine weitere Ausführungsform sieht vor, dass der Kühlkörper, welcher aus einem ersten metallischen Werkstoff hergestellt ist, auf seiner Oberfläche zumindest eine Kavität aufweist, die mit einem zweiten metallischen Werkstoff gefüllt ist, welcher eine höhere Wärmeleitfähigkeit als der erste metallische Werkstoff aufweist, wobei zumindest ein Substrat einer Leistungseinheit unmittelbar stoffschlüssig mit dem zweiten metallischen Werkstoff verbunden ist, aufweist. Beispielsweise ist der erste metallische Werkstoff Aluminium und der zweite metallische Werkstoff Kupfer. Durch eine mit dem zweiten metallischen Werkstoff gefüllte Kavität wird eine verbesserte thermische Anbindung der Leistungseinheiten an dem Kühlkörper erreicht.

Eine weitere Ausführungsform sieht vor, dass der zweite metallische Werkstoff im Wesentlichen planbündig mit der Oberfläche des Kühlkörpers abschließt. Unter einem planbündig mit der Oberfläche des Kühlkörpers ausgestalteten Abschluss ist ein ebener und im Wesentlichen zur Kühlkörperoberfläche stetiger Abschluss der Füllung der Kavität zu verstehen. Insbesondere bildet der zweite metallische Werkstoff eine ebene Oberfläche aus, die im Wesentlichen nahtlos in die Kühlkörperoberfläche übergeht. Durch eine derartige ebene Ausführung wird eine optimale thermische Anbindung an den Kühlkörper erreicht und es werden mechanische und/oder thermische Spannungen im mit dem zweiten metallischen Werkstoff verbundenen Substrat vermieden.

Eine weitere Ausführungsform sieht vor, dass jeder der mindestens zwei Leistungseinheiten eine mit dem zweiten metallischen Werkstoff gefüllte Kavität zugewiesen ist. Die mit dem zweiten metallischen Werkstoff gefüllten Kavitäten sind beispielsweise als Inseln ausgeführt, die eine größere Fläche aufweisen als die jeweiligen Substrate und an jeder der Substratkanten über das Substrat überstehen, wodurch eine verbesserte thermische Anbindung der Leistungseinheiten an dem Kühlkörper erreicht wird.

Eine weitere Ausführungsform sieht vor, dass der zweite metallische Werkstoff mittels eines additiven Verfahrens in die zumindest eine Kavität eingebracht ist. Beispielsweise ist der zweite metallische Werkstoff mittels Kaltgasspritzen in die zumindest eine Kavität eingebracht. Das additive Verfahren erlaubt, insbesondere im Vergleich zu einem Gießverfahren, eine sehr geringe Stärke des ersten metallischen Werkstoffs unterhalb der Kavität, sodass sich die Kühlrippen sehr nahe am zweiten metallischen Werkstoff, der eine höhere Wärmeleitfähigkeit als der erste metallische Werkstoff aufweist, befinden, sodass eine verbesserte thermische Anbindung an ein Kühlfluid erreicht wird.

Eine weitere Ausführungsform sieht vor, dass die Leistungseinheiten derartig auf der Oberfläche des Kühlkörpers angeordnet sind, dass durch Wärmespreizung eine optimale Entwärmung der Leistungshalbleiter stattfindet. Die Leistungseinheiten sind auf dem Kühlkörper, insbesondere in Relation zu einer Strömungsrichtung eines Kühlmittels, so orientiert und beabstandet, dass die in den Leistungshalbleitern der Leistungseinheiten, insbesondere näherungsweise punktuell, entstehende Abwärme möglichst gleichmäßig auf der Oberfläche des Kühlkörpers verteilt wird und so eine Wärmespreizung stattfindet. Durch eine derartige Anordnung wird eine höhere Robustheit des Leistungsmoduls während des Betriebes erreicht.

Eine weitere Ausführungsform sieht vor, dass der Kühlkörper konfiguriert ist, dass ein, insbesondere gasförmiges, Kühlmittel in eine Kühlmittelströmungsrichtung strömt, wobei die Kühlmittelströmungsrichtung im Wesentlichen parallel zur Oberfläche des Kühlkörpers verläuft. Das gasförmige Kühlmittel ist beispielsweise Luft. Insbesondere wird das Leistungsmodul einseitig durch einen Lüfter gekühlt, der in fluidtechnischer Verbindung mit den Kühlrippen des Kühlkörpers steht, sodass die Luft vom Lüfter im Wesentlichen parallel zur Oberfläche des Kühlkörpers über die Kühlrippen des Kühlkörpers strömt. Eine derartige Konfiguration ist kostengünstig und zuverlässig.

Eine weitere Ausführungsform sieht vor, dass die Leistungseinheiten quer zur Kühlmittelströmungsrichtung versetzt angeordnet sind. Durch eine versetzte Anordnung wird eine Wärmespreizung erreicht, die zu einer optimalen Entwärmung führt.

Eine weitere Ausführungsform sieht vor, dass das Leistungsmodul mindestens drei Leistungseinheiten umfasst, wobei ein Abstand zwischen den Leistungseinheiten in Kühlmittelströmungsrichtung und/oder quer zur Kühlmittelströmungsrichtung variiert. Beispielsweise ist jeweils eine Leistungseinheit einer Phase eines dreiphasigen Systems zugeordnet. Durch Variation der Abstände in Kühlmittelströmungsrichtung und/oder quer zur Kühlmittelströmungsrichtung wird durch Wärmespreizung eine optimale Entwärmung erreicht.

Eine weitere Ausführungsform sieht vor, dass ein Abstand zwischen den Leistungseinheiten in Kühlmittelströmungsrichtung zunimmt. Da sich das Kühlmittel in Kühlmittelströmungsrichtung unterhalb der Leistungseinheiten erwärmt, wird durch eine zunehmende Entfernung eine bessere Durchmischung von stark und schwach erwärmtem Kühlmittel erreicht. Ferner wird zumindest eine höhere Abkühlung bei zunehmendem Abstand erreicht, sodass in Kühlmittelströmungsrichtung zunehmende Abstände zu einer gleichmäßigeren Temperaturverteilung auf dem Kühlkörper führen.

Eine weitere Ausführungsform sieht vor, dass ein im Wesentlichen parallel zur Oberfläche des Kühlkörpers verlaufend angeordnetes Power-Board über frei positionierbare Kontakte mit den Leistungseinheiten verbunden ist, wobei die frei positionierbaren Kontakte stoffschlüssig mit den jeweiligen Substraten der Leistungseinheiten verbunden sind. Unter einem frei positionierbaren Kontakt ist beispielsweise ein Pin zu verstehen, der durch seine strukturellen Eigenschaften frei auf einem Substrat angeordnet werden kann. Derartige strukturelle Eigenschaften sind beispielsweise ein Fuß, der es dem Pin, beispielsweise durch eine stoffschlüssige Verbindung mit dem Substrat, erlaubt, ohne ein Gehäuse oder andere Stabilisierungsmittel frei und stabil auf dem Substrat angeordnet zu werden und/oder ein Taumelkreis, der eine Findung einer Bohrung im Power-Board erleichtert und für mehr Stabilität und Robustheit, z.B. bei einer thermischen Ausdehnung während des Betriebes, sorgt. Beispielsweise sind die frei positionierbaren Kontakte auf den jeweiligen Substraten aufgelötet und mittels einer Presspass-Verbindung mit dem Power-Board verbunden. Ein derartiger Kontakt ist beispielsweise aus Kupfer oder einer Kupferlegierung hergestellt, um einen geringen Widerstand und eine hohe Stromtragfähigkeit zu erreichen. Durch die freie Positionierbarkeit der Kontakte werden kurze Leitungswege und damit verbundene niedrige Induktivitäten erreicht, was Leistungseinheiten mit niedrigen Impedanzen und geringen Verlusten ermöglicht. Ferner wird kostengünstig und einfach ein zellindividuelles Design der Leistungseinheiten ermöglicht.

Eine weitere Ausführungsform sieht vor, dass die frei positionierbaren Kontakte bezogen auf eine Kraftmittellinie asymmetrisch ausgeführt sind. Entlang der Kraftmittellinie ist eine Einpresskraft in den frei positionierbaren Kontakt einleitbar. Eine asymmetrische Ausgestaltung der frei positionierbaren Kontakte erlaubt es, einen höheren Leiterquerschnitt bei gleichzeitig geringeren Werkzeugkosten im Vergleich zum Stand der Technik umzusetzen, wodurch die Stromtragfähigkeit der Kontakte erhöht wird.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Leistungsmoduls im Querschnitt,
- FIG 2: eine schematische Darstellung einer zweiten Ausgestaltung eines Leistungsmoduls in einer Draufsicht,
- FIG 3: eine schematische Darstellung einer dritten Ausgestaltung eines Leistungsmoduls in einer Draufsicht,
- FIG 4: eine schematische Darstellung einer vierten Ausgestaltung eines Leistungsmoduls in einer Draufsicht,
- FIG 5: eine schematische Darstellung einer fünften Ausgestaltung eines Leistungsmoduls in einer Draufsicht,
- FIG 6: eine schematische dreidimensionale Darstellung einer sechsten Ausgestaltung eines Leistungsmoduls,
- FIG 7: eine dreidimensionale Darstellung eines frei positionierbaren Kontaktes.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

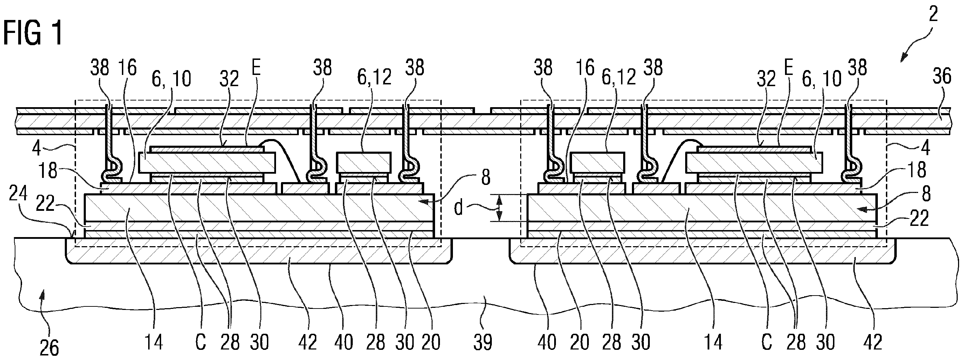

FIG 1 zeigt eine schematische Darstellung einer ersten Ausgestaltung eines Leistungsmoduls 2 im Querschnitt. Das Leistungsmodul 2 weist beispielhaft zwei Leistungseinheiten 4 auf, welche jeweils Leistungshalbleiter 6 und ein Substrat 8 umfassen. Die Leistungshalbleiter 6 sind als Transistor 10 oder als Diode 12 ausgeführt, wobei der Transistor 10 beispielsweise als Insulated-Gate-Bipolar-Transistor (IGBT), als Metalloxide-Semiconductor-Field-Effect-Transistor (MOSFET) oder als Feldeffekttransistor ausgeführt ist. Beispielsweise ist jedem der Transistoren 10 eine, insbesondere antiparalelle, Diode 12 zugewiesen.

Die Substrate 8 der beiden Leistungseinheiten 4 weisen eine dielektrische Materiallage 14 auf, die einen keramischen Werkstoff, beispielsweise Aluminiumnitrid oder Aluminiumoxid, oder einen organischen Werkstoff, beispielsweise einem Polyamid enthält. Die dielektrische Materiallage 14 weist eine Dicke d von 25 µm bis 400 µm, insbesondere 50 µm bis 250 µm, auf. Darüber hinaus weisen die Substrate 8 jeweils auf einer den Leistungshalbleitern 6 zugewandten Seite 16 eine, insbesondere strukturierte, obere Metallisierung 18 und auf einer den Leistungshalbleitern 6 abgewandten Seite 20 eine untere Metallisierung 22 auf, wobei die Substrate 8 jeweils unmittelbar stoffschlüssig mit einer Oberfläche 24 eines gemeinsamen Kühlkörpers 26 verbunden sind. Die obere Metallisierung 18 und die untere Metallisierung 22 sind beispielsweise aus Kupfer hergestellt. Die stoffschlüssige Verbindung 28 zum Kühlkörper 26 wird durch Löten oder Sintern hergestellt. Unter einer unmittelbar stoffschlüssigen Kontaktierung ist eine direkte Kontaktierung zu verstehen, die Verbindungsmittel zur Herstellung der stoffschlüssigen Verbindung wie Kleber, Lötzinn, Sinterpaste, ... einschließt, ein zusätzliches Verbindungselement wie einen zusätzlichen Leiter, einen Bonddraht, einen Abstandshalter, eine Bodenplatte, Wärmeleitpaste, ... jedoch ausschließt. Eine dem Substrat 8 zugewandte Seite 30 der Leistungshalbleiter 6 ist jeweils ebenfalls über eine stoffschlüssige Verbindung 28, die durch Löten oder Sintern hergestellt wird, mit der oberen Metallisierung 18 des Substrats 8 verbunden. Eine dem Substrat 8 abgewandte Seite 32 der Leistungshalbleiter 6 ist jeweils über eine Bondverbindung 34 mit der oberen Metallisierung 18 des Substrats 8 verbunden. Die Bondverbindung 34 umfasst beispielsweise mindestens einen Bonddraht, mindestens einen Ribbon-Bond und/oder andere Mittel zur Herstellung einer Bondverbindung.

Die Transistoren 10 in FIG 1 sind beispielhaft als IGBTs ausgeführt, deren Kollektor-Kontakt C auf der dem Substrat 8 zugewandte Seite 30 der Leistungshalbleiter 6 jeweils über eine stoffschlüssige Verbindung 28 mit der oberen Metallisierung 18 des Substrats 8 verbunden sind. Die Emitter-Kontakte E der als IGBTs ausgeführten Transistoren 10 sind, davon elektrisch isoliert, über Bondverbindungen 34 mit der oberen Metallisierung 18 des Substrats 8 verbunden. Die Gate-Kontakte der Transistoren 10 und die Bondverbindungen der Dioden 12 sind aus Gründen der Übersichtlichkeit in FIG 1 nicht dargestellt.

Ein im Wesentlichen parallel zur Oberfläche 24 des Kühlkörpers 26 verlaufend angeordnetes Power-Board 36 ist über frei positionierbare Kontakte 38 mit den Leistungseinheiten 4 verbunden, wobei die frei positionierbaren Kontakte 38 stoffschlüssig mit den oberen Metallisierungen 18 der jeweiligen Substrate 8 der Leistungseinheiten 4 verbunden sind. Die frei positionierbaren Kontakte 38 weisen einen elastisch nachgebenden Abschnitt auf und sind beispielsweise mit einer Presspass-Verbindung mit dem Power-Board 36 verbunden.

Der Kühlkörper 26 ist aus einem ersten metallischen Werkstoff 39 hergestellt. Auf seiner Oberfläche 24 sind Kavitäten 40 eingebracht, die mit einem zweiten metallischen Werkstoff 42 gefüllt sind, wobei der zweite metallische Werkstoff 42 eine höhere Wärmeleitfähigkeit als der erste metallische Werkstoff 39 aufweist. Beispielsweise ist der erste metallische Werkstoff 39 Aluminium und der zweite metallische Werkstoff 42 Kupfer. Jeder der mindestens zwei Leistungseinheiten 4 ist eine mit dem zweiten metallischen Werkstoff 42 gefüllte Kavität 40 zugewiesen, wobei der zweite metallische Werkstoff 42 im Wesentlichen planbündig mit der Oberfläche 24 des Kühlkörpers 26 abschließt und die unteren Metallisierungen 22 des jeweiligen Substrats 8 stoffschlüssig mit dem zweiten metallischen Werkstoff 42 verbunden sind. Insbesondere ist der zweite metallische Werkstoff 42 mittels eines additiven Verfahrens, beispielsweise mittels Kaltgasspritzen, in die Kavitäten eingebracht. Jeder der Leistungseinheiten 4 kann ein dedizierter Sensor, insbesondere Temperatursensor, zugewiesen sein, um die Temperatur der Leistungshalbleiter 6 zu überwachen.

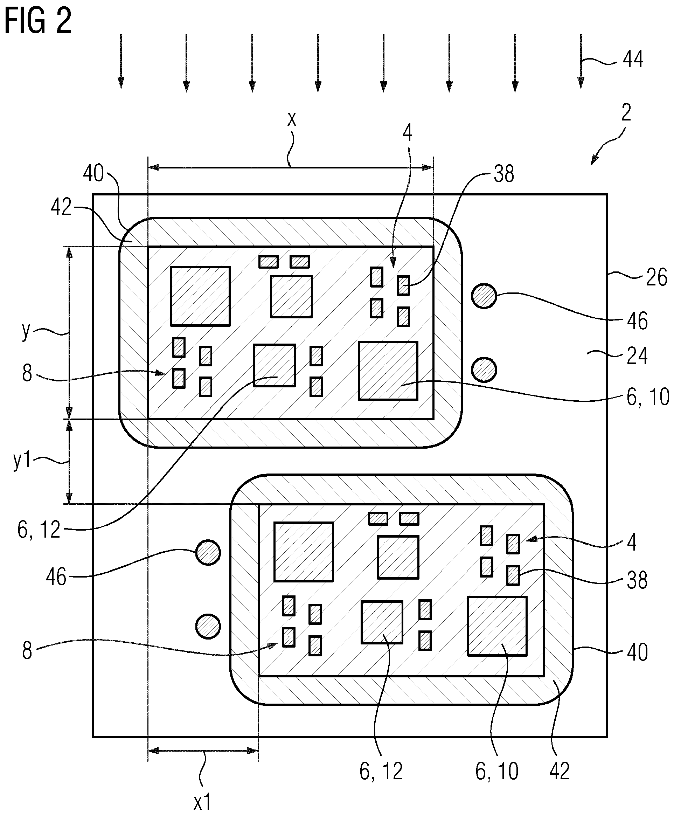

FIG 2 zeigt eine schematische Darstellung einer zweiten Ausgestaltung eines Leistungsmoduls 2 in einer Draufsicht. Der Kühlkörper 26 ist, beispielsweise durch Kühlrippen, dafür konfiguriert, dass ein gasförmiges Kühlmittel in eine Kühlmittelströmungsrichtung 44 strömt, wobei die Kühlmittelströmungsrichtung 44 im Wesentlichen parallel zur Oberfläche 24 des Kühlkörpers 26 verläuft. Das gasförmige Kühlmittel ist beispielsweise Luft, die über einen Lüfter in die Kühlmittelströmungsrichtung 44 über die Kühlrippen des Kühlkörpers 26 strömt. Das Leistungsmodul 2 weist beispielhaft zwei Leistungseinheiten 4 auf, die derartig auf der Oberfläche 24 des Kühlkörpers 26 beabstandet sind, dass durch Wärmespreizung eine optimale Entwärmung der Leistungshalbleiter 6 stattfindet. Ferner weisen die Leistungseinheiten 4 eine rechteckige Grundfläche mit identischen Abmessungen x, y auf. Um eine optimale Entwärmung der Leistungshalbleiter 6 zu erreichen sind die Leistungseinheiten 4, quer zur Kühlmittelströmungsrichtung 44 betrachtet, um einen ersten Querversatz x1 versetzt angeordnet. Darüber hinaus sind die Leistungseinheiten 4, in Kühlmittelströmungsrichtung 44 gesehen, um einen Längsversatz y1 beabstandet. Aufgrund der Größe der Oberfläche 24 des Kühlkörpers 26 sind der Querversatz x1 und der Längsversatz y1 kleiner als die jeweiligen Abmessungen x, y der Leistungseinheit 4. Durch die stoffschlüssige Verbindung der Leistungseinheiten 4 mit dem Kühlkörper 26 sind weniger Montagepunkte 46 erforderlich. Beispielhaft sind jeder Leistungseinheit 4 zwei Montagepunkte 46 zugeordnet, wobei der Kühlkörper 26 mindestens zwei Montagepunkte 46, insbesondere mindestens vier Montagepunkte 46, aufweist. Die weitere Ausführung des Leistungsmoduls 2 in FIG 2 entspricht der Ausführung in FIG 1.

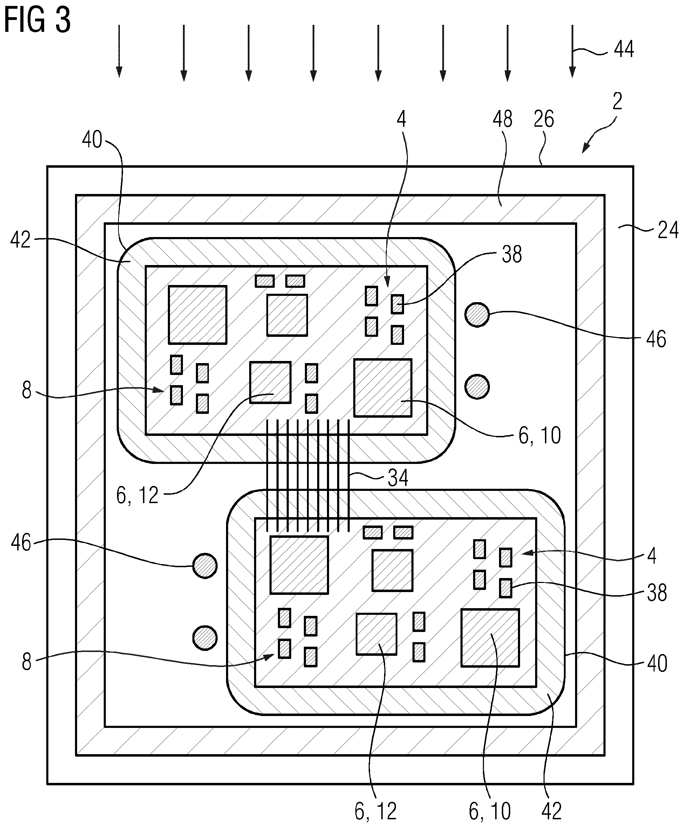

FIG 3 zeigt eine schematische Darstellung einer dritten Ausgestaltung eines Leistungsmoduls 2 in einer Draufsicht, wobei die zwei Leistungseinheiten 4 ein gemeinsames Gehäuse 48 aufweisen. Die beiden Leistungseinheiten 4 des Leistungsmoduls 2 sind über eine Bondverbindung 34 elektrisch leitend miteinander verbunden, wobei die Bondverbindung 34 eine Mehrzahl an Bonddrähten, Ribbon-Bonds und/oder andere Mittel zur Herstellung der Bondverbindung 34 aufweist. Beispielsweise umfasst das Gehäuse 48 eine Halbbrückenschaltung für Hochstromanwendungen, wobei zwei Halbbrücken, die jeweils einer Leistungseinheit 4 zugeordnet sind, parallelgeschaltet sind, um einen höheren Laststrom zu treiben. Die weitere Ausführung des Leistungsmoduls 2 in FIG 3 entspricht der Ausführung in FIG 2.

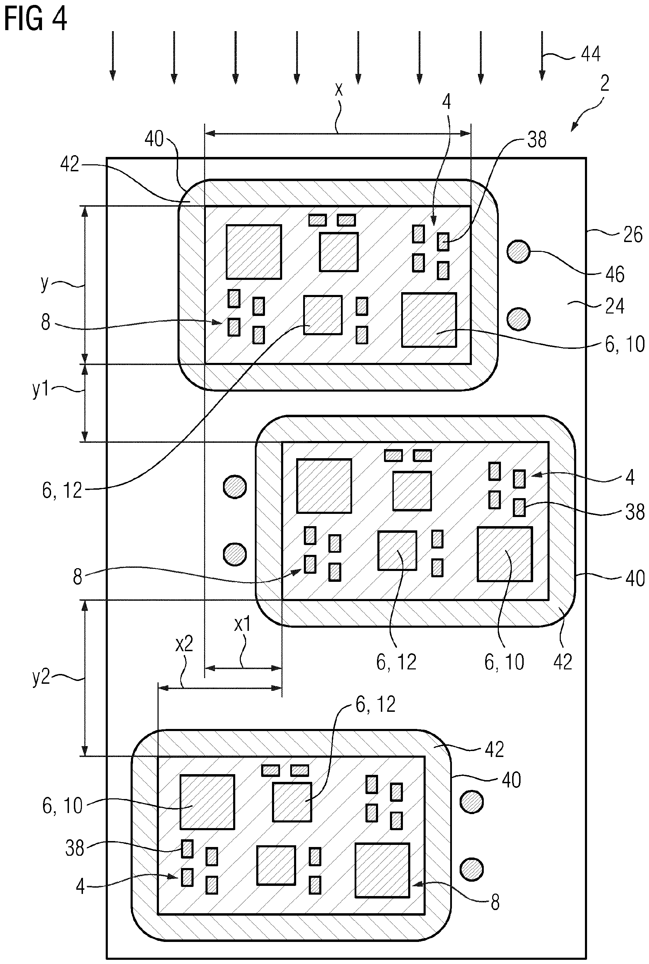

FIG 4 zeigt eine schematische Darstellung einer vierten Ausgestaltung eines Leistungsmoduls 2 in einer Draufsicht, wobei das Leistungsmodul 2 drei Leistungseinheiten 4 umfasst. Ein Abstand x1, x2, y1, y2 zwischen den Leistungseinheiten 4 variiert in Kühlmittelströmungsrichtung 44 und quer zur Kühlmittelströmungsrichtung 44. Um eine im Wesentlichen gleichmäßige Entwärmung der Leistungseinheiten 4 zu gewährleisten, sind diese derartig angeordnet, dass der Abstand y1, y2 zwischen den Leistungseinheiten 4 in Kühlmittelströmungsrichtung 44 zunimmt. Die weitere Ausführung des Leistungsmoduls 2 in FIG 3 entspricht der Ausführung in FIG 2.

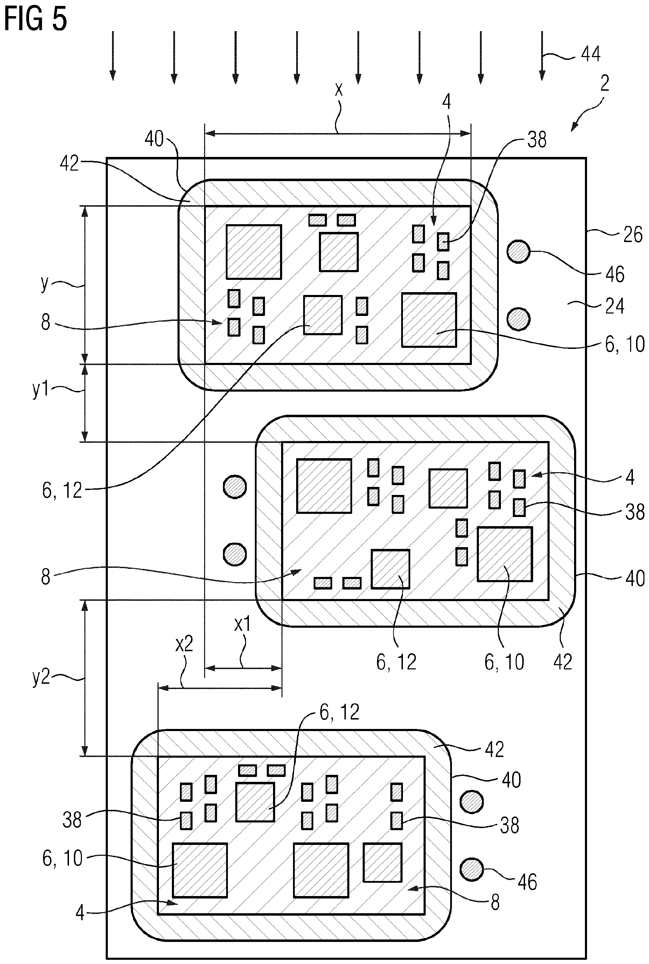

FIG 5 zeigt eine schematische Darstellung einer fünften Ausgestaltung eines Leistungsmoduls 2 in einer Draufsicht, wobei neben der Variation der Abstände x1, x2, y1, y2 zwischen den Leistungseinheiten 4 eine zusätzliche Wärmespreizung durch unterschiedliche Anordnung der Komponenten auf den Substraten 8 erreicht wird. Insbesondere werden die Leistungshalbleiter 6 mit den frei positionierbaren Kontakten 38 derartig auf den jeweiligen Substraten angeordnet, dass eine optimale Entwärmung der Leistungshalbleiter 4 stattfindet. Die Fläche der jeweiligen Substrate 8 kann für eine größere Wärmespreizung variiert werden. Die weitere Ausführung des Leistungsmoduls 2 in FIG 5 entspricht der Ausführung in FIG 4.

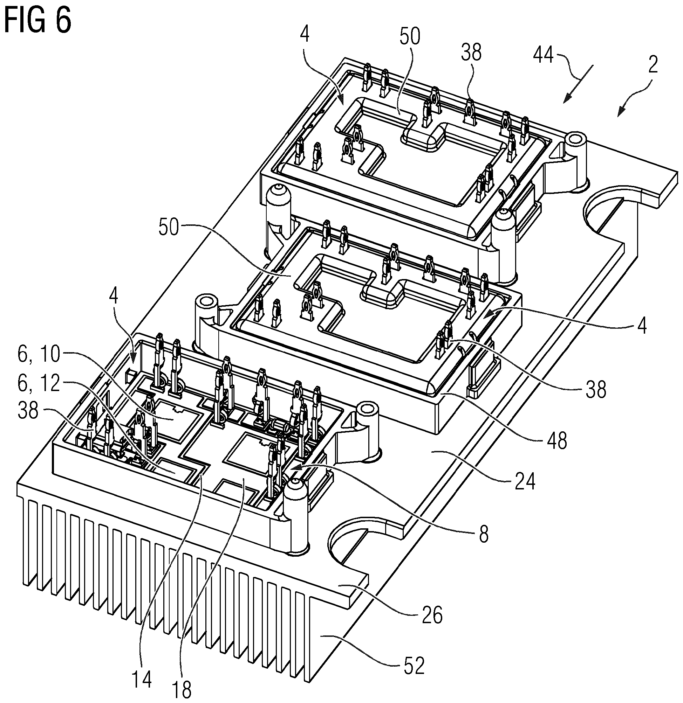

FIG 6 zeigt eine schematische dreidimensionale Darstellung einer sechsten Ausgestaltung eines Leistungsmoduls 2, wobei das Leistungsmodul 2 drei Leistungseinheiten 4 umfasst. Die Leistungseinheiten 4 weisen jeweils ein Gehäuse 48 mit einem Gehäusedeckel 50 auf, wobei der Gehäusedeckel 50 bei der vorderen Leistungseinheit 4 transparent dargestellt ist. Der Kühlkörper weist in Kühlmittelströmungsrichtung 44 verlaufend angeordnete Kühlrippen 52 auf. Beispielhaft sind die Kühlrippen 52 quer zur Kühlmittelströmungsrichtung 44 äquidistant angeordnet. Die weitere Ausführung des Leistungsmoduls 2 in FIG 6 entspricht der Ausführung in FIG 4.

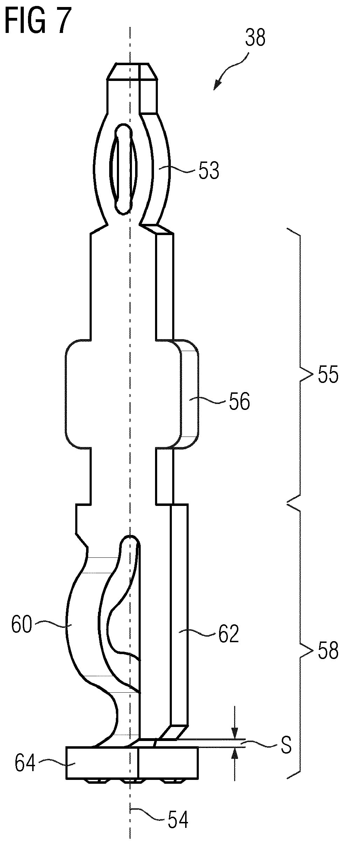

FIG 7 zeigt eine dreidimensionale Darstellung eines frei positionierbaren Kontaktes 38. Der frei positionierbare Kontakt 38 weist eine Einpresszone 53 auf, die mit dem Power-Board 36 verbindbar ist und ist, bezogen auf eine Kraftmittellinie 54 asymmetrisch ausgeführt, wobei entlang der Kraftmittellinie 54 eine Einpresskraft in den frei positionierbaren Kontakt 38 einleitbar ist. In einem Mittelteil 55 sind Positionierungshilfen 56 zur Ausrichtung des frei positionierbaren Kontakts 38, beispielsweise in einem Löt-Jig angebracht. Einem Unterteil 58 des frei positionierbaren Kontakts 38 ist als ein asymmetrischer Entlastungsabschnitt ausgeführt, der einen elastisch nachgebenden Abschnitt 60 und einen parallel dazu angeordneten Anschlag 62 aufweist, wobei der Anschlag über eine Spaltweite s von einem Fuß 64 beabstandet ist. Der Fuß 64 ist für eine stoffschlüssige Verbindung, beispielsweise durch Löten oder Sintern, konfiguriert. Insbesondere wird der frei positionierbare Kontakt 38 über den Fuß 64 mit der oberen Metallisierung 18 eines Substrats 8 stoffschlüssig verbunden. Der elastisch nachgebenden Abschnitt 60 weist eine S-förmige Federform mit einem definierten Federweg auf. Somit sind im Entlastungsabschnitt während des Einpressvorgangs oder während des Betriebes auftretende Kräfte, welche beispielsweise durch Erschütterungen verursacht werden, absorbierbar. Darüber hinaus sind durch die Elastizität Toleranzen ausgleichbar. Insbesondere wird eine Federkonstante des elastisch nachgebenden Abschnitts 60 mit Hilfe einer Querschnittsreduzierung durch Stanzen hergestellt. Die weitere Ausführung des frei positionierbaren Kontaktes 38 in FIG 7 entspricht der Ausführung in FIG 1.

Zusammenfassend betrifft die Erfindung ein Leistungsmodul 2 mit mindestens zwei Leistungseinheiten 4, welche jeweils mindestens einen Leistungshalbleiter 6 und ein Substrat 8 umfassen. Um den erforderlichen Bauraum des Leistungsmoduls zu verringern und eine Entwärmung zu verbessern, wird vorgeschlagen, dass der jeweils mindestens eine Leistungshalbleiter 6, insbesondere stoffschlüssig, mit dem jeweiligen Substrat 8 verbunden ist, wobei die Substrate 8 der mindestens zwei Leistungseinheiten 4 jeweils unmittelbar stoffschlüssig mit einer Oberfläche 24 eines gemeinsamen Kühlkörpers 26 verbunden sind.

## Patentansprüche

1. Leistungsmodul (2) mit mindestens zwei Leistungseinheiten (4), welche jeweils mindestens einen Leistungshalbleiter (6) und ein Substrat (8) umfassen,
wobei der jeweils mindestens eine Leistungshalbleiter (6), insbesondere stoffschlüssig, mit dem jeweiligen Substrat (8) verbunden ist,
wobei die Substrate (8) der mindestens zwei Leistungseinheiten (4) jeweils unmittelbar stoffschlüssig mit einer Oberfläche (24) eines gemeinsamen Kühlkörpers (26) verbunden sind.

2. Leistungsmodul (2) nach Anspruch 1,
wobei die Substrate (8) der Leistungseinheiten (4) jeweils eine dielektrische Materiallage (14) mit einer Wärmeleitfähigkeit von mindestens 25 W·m-1·K-1, insbesondere mindestens 100 W-m-1-K-1, und einer Dicke d von 25 µm bis 400 µm, insbesondere 50 µm bis 250 µm, aufweisen.

3. Leistungsmodul (2) nach einem der Ansprüche 1 oder 2,
wobei die Substrate (8) jeweils eine dielektrischen Materiallage (14) mit einer Dicke (d) von 25 µm bis 400 µm, insbesondere 50 µm bis 250 µm, aufweisen.

4. Leistungsmodul (2) nach einem der vorherigen Ansprüche,
wobei die mindestens zwei Leistungseinheiten (4) ein gemeinsames Gehäuse (48) aufweisen.

5. Leistungsmodul (2) nach einem der vorherigen Ansprüche,
wobei die mindestens zwei Leistungseinheiten (4), insbesondere über eine Bondverbindung (34), elektrisch leitend miteinander verbunden sind.

6. Leistungsmodul (2) nach einem der vorherigen Ansprüche,
wobei der Kühlkörper (26), welcher aus einem ersten metallischen Werkstoff (39) hergestellt ist, auf seiner Oberfläche (24) zumindest eine Kavität (40) aufweist, die mit einem zweiten metallischen Werkstoff (42) gefüllt ist, welcher eine höhere Wärmeleitfähigkeit als der erste metallische Werkstoff (39) aufweist,
wobei zumindest ein Substrat (8) einer Leistungseinheit (4) unmittelbar stoffschlüssig mit dem zweiten metallischen Werkstoff (42) verbunden ist.

7. Leistungsmodul (2) nach Anspruch 6,
wobei der zweite metallische Werkstoff (42) im Wesentlichen planbündig mit der Oberfläche (24) des Kühlkörpers (26) abschließt.

8. Leistungsmodul (2) nach einem der Ansprüche 6 oder 7,
wobei jeder der mindestens zwei Leistungseinheiten (4) eine mit dem zweiten metallischen Werkstoff (42) gefüllte Kavität (40) zugewiesen ist.

9. Leistungsmodul (2) nach einem der Ansprüche 6 bis 8,
wobei der zweite metallische Werkstoff (42) mittels eines additiven Verfahrens in die zumindest eine Kavität (40) eingebracht ist.

10. Leistungsmodul (2) nach einem der vorherigen Ansprüche,
wobei die Leistungseinheiten (4) derartig auf der Oberfläche (24) des Kühlkörpers (26) angeordnet sind, dass durch Wärmespreizung eine optimale Entwärmung der Leistungshalbleiter (6) stattfindet.

11. Leistungsmodul (2) nach einem der vorherigen Ansprüche,
wobei der Kühlkörper (26) konfiguriert ist, dass ein, insbesondere gasförmiges, Kühlmittel in eine Kühlmittelströmungsrichtung (44) strömt,
wobei die Kühlmittelströmungsrichtung (44) im Wesentlichen parallel zur Oberfläche (24) des Kühlkörpers (26) verläuft.

12. Leistungsmodul (2) nach Anspruch 11,
wobei die Leistungseinheiten (4) quer zur Kühlmittelströmungsrichtung (44) versetzt angeordnet sind.

13. Leistungsmodul (2) nach einem der Ansprüche 11 oder 12,
wobei das Leistungsmodul (2) mit mindestens drei Leistungseinheiten (4) umfasst,
wobei ein Abstand (x1, x2, y1, y2) zwischen den Leistungseinheiten (4) in Kühlmittelströmungsrichtung (44) und/oder quer zur Kühlmittelströmungsrichtung (44) variiert.

14. Leistungsmodul (2) nach einem der Ansprüche 11 bis 13,
wobei ein Abstand (y1, y2) zwischen den Leistungseinheiten (4) in Kühlmittelströmungsrichtung (44) zunimmt.

15. Leistungsmodul (2) nach einem der vorherigen Ansprüche,
wobei ein im Wesentlichen parallel zur Oberfläche (24) des Kühlkörpers (26) verlaufend angeordnetes Power-Board (36) über frei positionierbare Kontakte (38) mit den Leistungseinheiten (4) verbunden ist,
wobei die frei positionierbaren Kontakte (38) stoffschlüssig mit den jeweiligen Substraten (8) der Leistungseinheiten (4) verbunden sind.

16. Leistungsmodul (2) nach Anspruch 15,
wobei die frei positionierbaren Kontakte (38) bezogen auf eine Kraftmittellinie (54) asymmetrisch ausgeführt sind.

17. Stromrichter mit mindestens einem Leistungsmodul (2) nach einem der Ansprüche 1 bis 16.
